(19) Europäisches Patentamt
European Patent Office
Office européen des brevets

(11) EP 4 426 081 A1

(12) EUROPÄISCHE PATENTANMELDUNG

(43) Veröffentlichungstag:
04.09.2024  Patentblatt 2024/36

(21) Anmeldenummer: 23159766.7

(22) Anmeldetag: 02.03.2023

(51) Internationale Patentklassifikation (IPC):
H05K 13/08 (2006.01)    G06Q 10/063 (2023.01)
G06Q 10/04 (2023.01)    G06Q 50/04 (2012.01)
G05B 19/418 (2006.01)

(52) Gemeinsame Patentklassifikation (CPC):
H05K 13/085; G05B 19/41865; G06Q 10/04;
G06Q 10/0631; G06Q 50/04; H05K 13/0857

(84) Benannte Vertragsstaaten:
AL AT BE BG CH CY CZ DE DK EE ES FI FR GB
GR HR HU IE IS IT LI LT LU LV MC ME MK MT NL
NO PL PT RO RS SE SI SK SM TR
Benannte Erstreckungsstaaten:
BA
Benannte Validierungsstaaten:
KH MA MD TN

(71) Anmelder: Siemens Aktiengesellschaft
80333 München (DE)

(72) Erfinder:
• Pfaffinger, Alexander
  81739 München (DE)
• Royer, Christian
  85521 Ottobrunn (DE)

(74) Vertreter: Siemens Patent Attorneys
Postfach 22 16 34
80506 München (DE)

(54) **VERFAHREN ZUM BESTÜCKEN VON LEITERPLATTEN MITTELS MEHRERER RÜSTUNGEN AUF EINER BESTÜCKUNGSLINIE ÜBER EINEN KURZFRISTIGEN PLANUNGSZEITRAUM**

(57) Die Erfindung beansprucht ein Verfahren zum Bestücken von Leiterplatten (120) mittels mehrerer Rüstungen (165, 170) auf einer Bestückungslinie (110), wobei eine Rüstung (165, 170) eine Anzahl an Bauelementtypen (160) umfasst, die zur Bestückung einer der Rüstung (165, 170) zugeordneten Rüstfamilie (210, 215) von Leiterplattentypen (122) ausreicht, wobei eine Rüstung (165, 170) realisierbar ist durch eine Anzahl von Wechseltischen (140), die an der Bestückungslinie (110) angebracht sind und die Vorräte von Bauelementen (155) der Bauelementtypen (160) umfassen, wobei ein Planungshorizont zum Bestücken der Leiterplatten in mehrere Zeitintervalle fester Länge unterteilt ist und während eines Zeitintervalls unterschiedliche Rüstungen (165, 170) an der Bestückungslinie (110) angebracht werden können, wobei von den Rüstungen mindestens eine Festrüstung (165) gebildet wird, die während des Planungshorizonts unverändert bleibt und mehrfach an der Bestückungslinie (110) eingesetzt werden kann und wobei mindestens eine Variantenrüstung (170) während des Planungshorizonts gebildet wird, die nur temporär auf Wechseltischen (140) aufgerüstet und nach der Bestückung von Leiterplatten (120) einer Rüstfamilie wieder abgerüstet wird, und wobei das Verfahren folgende Schritte umfasst:

a) Erfassen einer Anzahl Leiterplattentypen (122) mit dem jeweiligen Leiterplattentyp zugeordneten Leiterplatten (120), die auf der Bestückungslinie (110) innerhalb des Planungshorizonts (205) bestückt werden sollen;
b) Erfassen der Anzahl der Bauelementtypen zur Bestückung einer oder mehrerer Leiterplatten eines Leiterplattentyps,
c) Erfassen von Wahrscheinlichkeiten für das Eintreffen von Aufträgen zur jeweiligen Bestückung eines Leiterplattentyps innerhalb eines Zeitintervalls;
d) Zuordnen (315) von Leiterplattentypen (122) an eine Festrüstungs-Rüstfamilie, wobei alle Bauelementtypen zur Bestückung einer Leiterplatte eines Leiterplattentyps der zugeordneten Leiterplattentypen hinsichtlich ihres Platzverbrauchs in den in der Festrüstung verfügbaren Spuren Platz haben und in der Festrüstung gerüstet werden;
e) Optimieren dieser Zuordnung der Leiterplattentypen derart, dass eine in einem Zeitintervall erwartete Anzahl der in der mindestens einen Variantenrüstung zu rüstenden Bauelementtypen minimiert wird,
f) Bestücken der Leiterplatten (120) aller in den Zeitintervallen auszuführenden Aufträge auf der Bestückungslinie (110) mit Hilfe der optimierten Zuordnung der Leiterplattentypen.

# FIG 1

**EP 4 426 081 A1**

**Beschreibung**

Die Erfindung betrifft ein Verfahren zum Bestücken von Leiterplatten mittels mehrerer Rüstungen auf einer Bestückungslinie, wobei eine Rüstung eine Anzahl an Bauelementtypen umfasst, die zur Bestückung einer der Rüstung zugeordneten Rüstfamilie von Leiterplattentypen ausreicht,
und eine Steuereinrichtung sowie ein zugehöriges Computerprogrammprodukt.

Insbesondere im Bereich der Elektronikproduktion werden zu fertigende Leiterplatten bzw. Baugruppen auf SMT-Bestückungslinien durch Oberflächenmontage (SMT = surface mounted technology) hergestellt. Die Elektronikproduktion bzw. -fertigung ist geprägt durch hohe Anforderungen an kurze Durchlaufzeiten, hohe Produktivität (u.a. kurze Umrüstzeiten, kurze Produktionszeiten, usw.) und hohe Flexibilität.

Mehrere Bestückungsautomaten, die üblicherweise durch ein Transportsystem verbunden sind, und die z.B. zum Fertigen bzw. Produzieren bzw. Bestücken von (Elektronik-)baugruppen zusammenwirken, stellen eine Bestückungslinie dar.

In den industriellen Fertigungswerken im Bereich der Elektronikproduktion werden zu fertigende Baugruppen (bzw. Leiterplatten) in Aufträgen mit fest vorgegebenen Losgrößen produziert.

Durch die Losgrößen wird implizit festgelegt, wie häufig ein Baugruppentyp zu produzieren ist. Je kleiner die Losgröße eines Baugruppentyps ist, umso häufiger müssen Baugruppen diesen Baugruppentyps produziert werden und umso größer sind die Rüstaufwände.

In der variablen Fertigung werden für einen kurzfristigen (Planungs-)Zeitraums (in der Regel 1-3 Tage) innerhalb eines längerfristigen Planungshorizonts bzw. -zeitraums (in der Regel mindestens 6 Monate) die zu fertigenden Baugruppen in Rüstfamilien aufgeteilt. Eine Rüstfamilie ist dabei eine Menge von Baugruppentypen, die mit einer Bauelement-Rüstung der Bestückungslinie produzierbar ist. Mit anderen Worten ausgedrückt umfasst eine Rüstfamilie, auch Cluster genannt, eine Menge von Losen, die innerhalb einer Rüstung gefertigt werden kann. Alle Baugruppen der Baugruppentypen einer Rüstfamilie können also nacheinander ohne Umrüsten auf der Bestückungslinie gefertigt werden.

Die Rüstungen der Rüstfamilien werden zur Produktion aufgerüstet und nachher wieder abgerüstet. (Dies Rüstungen werden als variable Rüstungen bzw. Variantenrüstung bezeichnet.) Das Auslagern und manuelle Aufrüsten der Förderer auf die Wechseltische im Vorrüstbereich benötigt für alle (Wechsel- )Tische einer Rüstfamilie ca. 6-10 Stunden und bedeutet daher sehr viel Aufwand.

Bei der Festrüstungsfertigung werden die Rüstungen für die zu fertigenden Baugruppen auf Wechselwägen/- tischen längerfristig (6-12 Monate) fest gerüstet. Wird eine Linie mit einer Festrüstung betrieben, so bleiben die Wechseltische dann an der Linie fest am Platz. Bei mehreren Festrüstungen pro Linie werden beim Rüstfamilienwechsel die Wechseltische entsprechend getauscht. In der Praxis wird der Tausch ganzer festgerüsteter Wechseltische bevorzugt. Das Auf- und Abrüsten von Wechseltischen ist in der täglichen Produktion nicht mehr nötig.

Variable bzw. Varianten-Fertigungen sind im High-Mix-LowVolume Bereich sehr gefragt, d.h. sehr viele unterschiedliche Baugruppentypen sind mit geringer Stückzahl zu fertigen. In diesem Bereich werden die Fertigungen, wenn möglich, auch gemischt betrieben, d.h. ein Teil der Produkte wird mit Festrüstung gefertigt und der andere Teil mit Variantenrüstungen.

Das größte Problem stellt meist der Rüstaufwand für die variablen Rüstungen dar.

Festrüstungen dienen in diesem Bereich dann hauptsächlich dafür, den Rüstaufwand für die variablen Rüstungen zu reduzieren. Zudem können durch den Einsatz von Festrüstungen auch Stillstandzeiten der Linien vermieden werden, wenn variable Rüstungen nicht rechtzeitig fertiggestellt werden.

Aus EP 2 893 791 B1 ist ein Verfahren zur Bestimmung einer Festrüstung für eine Bestückungslinie bekannt.

Mit diesem Verfahren lassen sich Festrüstungs-Rüstfamilien erstellen, die für einen langfristigen Zeitraum ausgelegt sind bzw. eine möglichst lange Laufzeit besitzen oder mit denen möglichst viele Aufträge gefertigt werden können. Festrüstungen, die darauf abzielen, den Rüstaufwand der Baugruppen, die nicht mit Festrüstungen gefertigt werden, zu minimieren, lassen sich damit nicht erstellen.

Die Aufgabe der Erfindung besteht darin, ein gegenüber dem oben genannten Stand der Technik verbessertes Verfahren sowie eine zugehörige Steuereinrichtung zu entwickeln, bei dem mindestens eine Festrüstung für eine Menge von Baugruppentypen gebildet wird, wobei der Rüstaufwand für Baugruppentypen, die nicht in der Festrüstung gefertigt werden können, minimiert wird.

Diese Aufgabe wird durch die unabhängigen Ansprüche gelöst. Vorteilhafte Weiterbildungen sind Gegenstand der abhängigen Ansprüche.

Die Erfindung beansprucht ein Verfahren zum Bestücken von Leiterplatten mittels mehrerer Rüstungen auf einer Bestückungslinie, wobei eine Rüstung eine Anzahl an Bauelementtypen umfasst, die zur Bestückung einer der Rüstung zugeordneten Rüstfamilie von Leiterplattentypen ausreicht,

- wobei eine Rüstung realisierbar ist durch eine Anzahl von Wechseltischen, die an der Bestückungslinie angebracht sind und die Vorräte von Bauelementen der Bauelementtypen umfassen,

- wobei ein Planungshorizont zum Bestücken der Leiterplatten in mehrere Zeitintervalle fester Länge unterteilt ist und während eines Zeitintervalls unterschiedliche Rüstungen an der Bestückungslinie angebracht werden können,

- wobei von den Rüstungen mindestens eine Festrüstung gebildet wird, die während des Planungshorizonts unverändert bleibt und mehrfach an der Bestückungslinie eingesetzt werden kann,

- und wobei mindestens eine Variantenrüstung während des Planungshorizonts gebildet wird, die nur temporär auf Wechseltischen aufgerüstet und nach der Bestückung von Leiterplatten einer Rüstfamilie wieder abgerüstet wird, und wobei das Verfahren folgende Schritte umfasst:

a) Erfassen einer Anzahl Leiterplattentypen mit dem jeweiligen Leiterplattentyp zugeordneten Leiterplatten, die auf der Bestückungslinie innerhalb des Planungshorizonts bestückt werden sollen;

b) Erfassen der Anzahl der Bauelementtypen zur Bestückung einer oder mehrerer Leiterplatten eines Leiterplattentyps,

c) Erfassen von Wahrscheinlichkeiten für das Eintreffen von Aufträgen zur jeweiligen Bestückung eines Leiterplattentyps innerhalb eines Zeitintervalls;

d) Zuordnen von Leiterplattentypen an eine Festrüstungs-Rüstfamilie, wobei alle Bauelementtypen zur Bestückung einer Leiterplatte eines Leiterplattentyps der zugeordneten Leiterplattentypen hinsichtlich ihres Platzverbrauchs in den in der Festrüstung verfügbaren Spuren Platz haben und in der Festrüstung gerüstet werden;

e) Optimieren dieser Zuordnung der Leiterplattentypen derart, dass eine in einem Zeitintervall erwartete Anzahl der in der mindestens einen Variantenrüstung zu rüstenden Bauelementtypen minimiert wird,

f) Bestücken der Leiterplatten aller in den Zeitintervallen auszuführenden Aufträge auf der Bestückungslinie mit Hilfe der optimierten Zuordnung der Leiterplattentypen.

Mit anderen Worten ausgedrückt wird bei der genannten Optimierung der Erwartungswert der Summe der zu rüstenden Bauelemente minimiert.

Der Planungshorizont ist länger als ein Zeitintervall, vorzugsweise längerfristig (in der Regel länger als ein halbes Jahr), ausgelegt. Er ist in mehrere Zeitintervalle fester Länge unterteilt. Diese Zeitintervalle repräsentieren vorzugsweise kurzfristige Zeiträume, die in der Regel 1 bis 3 Tage dauern. In der Regel werden die Variantenrüstungen während eines solchen Zeitintervalls auf- und wieder abgerüstet. Die Länge der Zeitintervalle werden beim erfindungsgemäßen Verfahren vorgegeben und sind von den Aufträgen und auch von der Länge des Planungshorizont unabhängig.

Vorzugsweise wird eine prognostizierte Anzahl an Aufträgen für einen Leiterplattentyp innerhalb des Planungshorizonts erfasst. Es wird angenommen, dass maximal ein Auftrag für einem Leiterplattentyp in einem kurzfristigen Zeitraum gefertigt wird. Entsprechend ist die prognostizierte Anzahl kleiner oder gleich der Anzahl der kurzfristigen Zeiträume. Ein (Bestückungs-)auftrag umfasst eine Stückzahl bzw. Menge von Baugruppen eines Baugruppentyps. Die Aufträge sind in der Regel gleichmäßig auf die Zeitintervalle verteilt sind. Damit ergibt sich die Wahrscheinlichkeit für das Eintreffen von Aufträgen zur jeweiligen Bestückung eines Leiterplattentyps innerhalb eines Zeitintervalls aus der prognostizierten Anzahl an Aufträgen dividiert durch die Anzahl an Zeitintervallen, wobei maximal ein Auftrag pro Zeitintervall erledigt werden kann.

Die Erfindung bringt somit den Vorteil mit sich, dass die Flexibilität in der Produktion der Baugruppen und der Produkte erhöht wird, in denen die gefertigten Baugruppen eingesetzt werden sollen. Der Rüstaufwand im Vorrüstbereich wird reduziert, wodurch kürzere Umrüstzeiten entstehen. Produktionszeiten und Stillstandzeiten werden reduziert. Es ist die Produktion mit niedrigen Losgrößen möglich.

Das obige Verfahren kann beliebig oft iteriert werden.

Das erfindungsgemäße Verfahren und dessen Weiterbildungen/Ausführungsformen können zentral auf einem Steuerungseinrichtung vorzugsweise der nachstehend beschriebenen Art ausgeführt werden. Das Optimieren der Zuordnung der Leiterplattentypen kann dann abgebrochen werden, wenn während einer vorbestimmten Bearbeitungszeit keine Zuordnung gefunden werden konnte.

Das Ergebnis der Optimierung der Zuordnung der Leiterplattentypen kann in einer zur Steuerung der Bestückung dieser Baugruppen geeignete Form, vorzugsweise computerlesbar, ausgegeben werden und dann zur Steuerung bzw. Regelung der Bestückung der Baugruppen beispielsweise mit einer Steuereinrichtung beispielsweise der unten angegeben Art verwendet werden.

Beim obigen Verfahren, das vorzugsweise computerimplementiert ausgestaltet ist, kann unter "erfasst" bzw. "erfassbar" bzw. "vorgegeben" bzw. "vorgebbar" verstanden werden, dass ein oder mehrere Eingabewerte bereits, beispielsweise durch Standard(werte), festgelegt sind oder von einem Benutzer und/oder durch Ausgabewerte eines vorgeschalteten computerimplementierten Verfahrens vorgegeben bzw. festgelegt werden und/oder vorgebbar bzw. festlegbar sind. Damit werden diese Eingabewerte vom computer-implementierten Verfahren erfasst.

Das Optimieren der Zuordnung der Leiterplattentypen kann mittels Gemischt Ganzzahliger Nicht Linearer Programmierung (MINLP) erfolgen.

Ein Spezialfall von Optimierungsmethoden, die für die oben genannte Optimierung verwendet werden können, ist die lineare Optimierung. Sie befasst sich mit der Optimierung linearer Zielfunktionen über einer Menge, die durch lineare Gleichungen und Ungleichungen eingeschränkt ist. Sie ist Grundlage der Lösungsverfahren der (gemischt-) ganzzahligen linearen Optimierung.

Schwieriger als die lineare Optimierung ist der Fall der nichtlinearen ganzzahliger Optimierung (MINLP), bei der die Zielfunktion, die Nebenbedingungen (NB) oder beide nichtlinear vorliegen können. Die Lösung wird erreicht, indem geeignete lineare Approximationen verwendet werden, so dass Standardsolver direkt verwendet werden können. Darüber hinaus können die oben genannten Standardsolver jeweils bestimmte Arten von nichtlinearen Problemen bereits lösen. Außerdem gibt es zusätzliche Solver, die auf die Lösung nichtlinearer Probleme spezialisiert sind (z.B. ANTIGONE, BARON).

In der Gemischt Ganzzahligen Nicht Linearen Programmierung kann die nichtlineare Zielfunktion durch eine lineare Zielfunktion approximiert werden. Die Minimierung der nichtlinearen Zielfunktion in Form von einer Minimierung der erwarteten Anzahl der in der mindestens einen Variantenrüstung zu rüstenden Bauelementtypen kann durch Maximierung der linearen Zielfunktion in Form von der Summe der prognostizierten Aufträge multipliziert mit der Anzahl der Bauelementtypen der Leiterplattentypen, die den Festrüstungs-Rüstfamilien zugeordnet sind, approximiert werden. Die genannte Optimierung der Zuordnung der Leiterplattentypen kann mit Hilfe einer Gemischt Ganzzahligen Linearen Programmierung mit der linearen Zielfunktion durchgeführt werden.

Die Gemischt Ganzzahlige Programmierung stellt einen globalen Optimierungsansatz dar, der leicht erweiterbar ist und für die kommerzielle Lösungsverfahren bzw. Lösungsvorrichtungen, auch Solver genannt, erhältlich sind. Mittels Gemischt Ganzzahliger Programmierung können in einer Vielzahl möglicher Lösungen globale Maxima gefunden werden, so dass eine besonders gute Lösung gefunden werden kann. Im Zusammenhang mit MIP (mixed integer programming) bzw. MILP (gemischt ganzzahlige Lineare Programmierung) können für kleine IP-Programme (ganzzahlige Optimierungsmodelle) Standardsolver wie z.B. CPLEX, Scip, Gurobi, Xpress verwendet werden.

Zweckmäßig ist es, dass die Zuordnung der Leiterplattentypen an die Rüstfamilien unter der Randbedingung erfolgt, dass ein maximaler Füllgrad der Wechseltische bzw. ein maximaler Platzverbrauch auf den Wechseltischen nicht überschritten wird.

Des Weiteren ist es zweckmäßig, dass die Summe der Produktionszeiten der Baugruppentypen einer Rüstfamilie eine untere Produktionszeitschranke nicht unterschreiten darf.

Ein weiterer Aspekt der Erfindung sieht eine Steuerungseinrichtung, insbesondere umfassend mindestens eine Recheneinheit bzw. Prozessor, vor. Diese Steuerungseinrichtung ist zum Bestücken von Leiterplatten mittels einer Rüstung auf einer Bestückungslinie ausgelegt, wobei die Rüstung eine Anzahl an Bauelementtypenumfasst, die zur Bestückung einer der Rüstung zugeordneten Rüstfamilie von Leiterplattentypen ausreicht,

- wobei die Rüstung realisierbar ist durch eine Anzahl von Wechseltischen, die an der Bestückungslinie angebracht sind und die Vorräte von Bauelementen der Bauelementtypen umfassen,
- wobei ein Planungshorizont zum Bestücken der Leiterplatten in mehrere Zeitintervalle fester Länge unterteilt ist und während eines Zeitintervalls unterschiedliche Rüstungen an der Bestückungslinie angebracht werden können,
- wobei von den Rüstungen mindestens eine Festrüstung gebildet wird, die während des Planungshorizonts unverändert bleibt und mehrfach an der Bestückungslinie eingesetzt werden kann,
- und wobei mindestens eine Variantenrüstung während des Planungshorizonts gebildet wird, die nur temporär auf Wechseltischen aufgerüstet und nach der Bestückung von Leiterplatten einer Rüstfamilie wieder abgerüstet wird,

und wobei die Steuereinrichtung dazu eingerichtet ist, die oben genannten Schritte auszuführen.

Es kann die erfindungsgemäße Steuereinrichtung bzw. Steuerungssystem zentral für mehrere Bestückungslinien geben. Es können eine oder mehrere Steuerungsvorrichtungen, die dann jeweils für die einzelnen Bestückungslinien zuständig sind, mit der Steuerungseinrichtung verbunden sein. Die Steuerungseinrichtung kann auch abgesetzt von der Steuerungsvorrichtung/den Steuerungsvorrichtungen und gegebenenfalls außerhalb des Fertigungswerks in einem Rechenzentrum bzw. in einer Cloud (Rechnerwolke) angeordnet sein. Es ist auch möglich, dass je eine Steuereinrichtung für mehrere Bestückungslinien bzw. eine Steuereinrichtung pro Bestückungslinie vorgesehen ist. Bei der zuletzt genannten dezentralen Lösung kommunizieren die mehreren Steuereinrichtungen entsprechend untereinander über ein drahtgebundenes und/oder drahtloses Kommunikationsnetzwerk.

Die Einrichtung(en), das System bzw. die Vorrichtung(en) und ggf. dazugehörige Einheit(en) sind dazu eingerichtet, solche Verfahrensschritte auszuführen, und können hardware-, firmware- und/oder softwaremäßig implementiert sein.

Ein weiterer Aspekt der Erfindung ist ein Computerprogramm(produkt) umfassend einen durch eine Recheneinheit bzw. Prozessor ausführbaren Programmkode oder mehrere durch mehrere Recheneinheiten ausführbare und zusammenwirkende Programmkodemodule, welches oder welche Befehle aufweisen, die, die Ausführung des Verfahrens nach, einer der oben genannten Ausführungsformen auf einer Steuereinrichtung, vorzugsweise der oben genannten Art veranlassen.

Das Computerprogramm bzw. -produkt kann auf einem computerlesbaren Speichermedium bzw. Datenträger gespeichert sein. Es ist möglich, dass das Computerprogramm(-produkt) in ein Datenträgersignal eingebunden ist, das für ein Herunterladen desselben von einem Server auf ein Speichermedium vorgesehen ist. Das Computerprogramm bzw. -produkt kann in einer üblichen Programmiersprache (z.B. C++, Java) erstellt sein. Eine Verarbeitungseinrichtung bzw. Prozessor für die Ausführung dessen Programmkodes/Programmkodemodule kann einen marktüblichen Computer oder Server mit entsprechenden Eingabe-, Ausgabe- und Speichermitteln umfassen. Diese Verarbeitungseinrichtung bzw. Recheneinheit kann in der Steuereinrichtung bzw. - vorrichtung bzw. in deren Einheiten integriert sein.

Das computer-implementierte Verfahren betrifft auch sogenannte Cloud-Dienste (Cloud = Rechnerwolke). Eine Rechnerwolke um fasst in der Regel ein oder mehrere Server, die von einem Cloud-Diensterbringers betrieben werden und dazu eingerichtet sind, einen Cloud-Dienst an einen Dienstnehmer z.B. einem Werkverbund zu liefern. Demnach kann das System in einer Rechnerwolke realisiert sein.

Die Steuereinrichtungen bzw. die Steuerungsvorrichtungen sowie das Computerprogramm(-produkt) und computerlesbaren Medien bzw. Datenträger bzw. Datenträgersignal können analog zum oben genannten Verfahren und dessen Weiterbildungen weiter- bzw. ausgebildet sein.

Weitere Vorteile, Einzelheiten und Weiterbildungen der Erfindung ergeben sich aus der nachfolgenden Beschreibung von Ausführungsbeispielen in Verbindung mit den Zeichnungen.

Figur 1 zeigt beispielhaft ein Bestückungssystem, und
Figur 2 zeigt ein Ablaufdiagramm des erfindungsgemäßen Verfahrens.

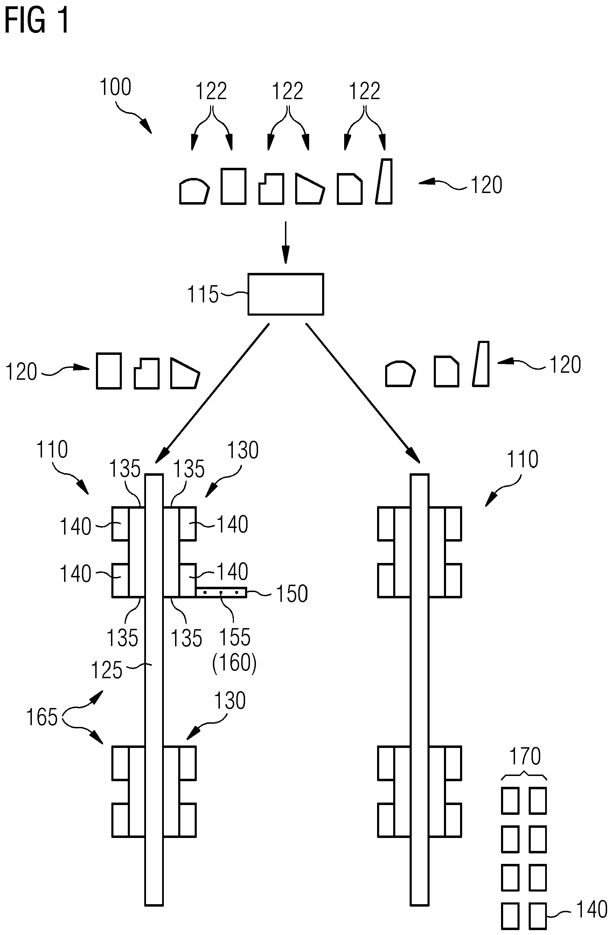

Figur 1 zeigt ein Bestückungssystem 100 mit einer oder mehreren Bestückungslinien. Das Bestückungssystem 100 umfasst eine oder mehrere Bestückungslinien 110 und ein Steuerungssystem 115.

Jede Bestückungslinie 110 umfasst ein optionales Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Wechseltisch 140 Bauelemente bzw. -teile 155 aufzunehmen und an einer vorbestimmten Position auf der Baugruppe bzw. Leiterplatte 120 zu positionieren, die sich auf dem Transportsystem 125 befindet.

Während des Bestückungsvorgangs steht die Leiterplatte 120 bezüglich des Bestückungsautomaten 130 üblicherweise still. Die Wechseltische 140 umfassen jeweils eine Vielzahl von Förderern bzw. Zuführungseinrichtungen 150, von denen in Figur 1 exemplarisch nur eine dargestellt ist. Jede Zuführungseinrichtung 150 hält einen Vorrat von Bauelementen 155 eines vorbestimmten Bauelementtyps 160 bereit. Für die Bauelemente 155 hat die Zuführungseinrichtung 150 ein Fassungsvermögen, das üblicherweise in Spuren ausgedrückt wird. Eine Spur ist üblicherweise 8 mm breit und die Zahl der Spuren jeder Zuführungseinrichtung 150 ist beschränkt, beispielsweise auf 40. Bauelemente 155 des gleichen Bauelementtyps 160 sind üblicherweise bereitgestellt in einem Gurt, auf einem Tablett oder in einer Röhre. Jeder Bauelementtyp 160 benötigt Platz in der Zuführungseinrichtung 150 mit einer vorbestimmten Anzahl an Spuren, die üblicherweise aneinander angrenzen müssen.

Jede Zuführungseinrichtung 150 kann zur Bereithaltung unterschiedlicher Bauelemente 155 konfiguriert werden und üblicherweise können unterschiedliche Zuführungseinrichtungen 150 an einem Wechseltisch 140 angebracht werden. Wird ein Bauelement 155 eines Bauelementtyps 160 am Bestückungsautomaten 130 benötigt, der nicht in einem der Wechseltische 140 vorhanden ist, so wird üblicherweise nicht einer der angebrachten Wechseltische 140 mit den benötigten Bauelementen 155 versehen, sondern komplett gegen einen anderen, entsprechend bestückten Wechseltisch 140 ausgetauscht. Das Aufrüsten eines einzuwechselnden Wechseltischs 140 mit Bauelementen 155 wird Vorrüstung genannt und kann eine Bearbeitungszeit im Stundenbereich erfordern.

Da ein Wechsel von Wechseltischen 140 an der Bestückungslinie 110 üblicherweise mit einem Produktionsstillstand verbunden ist, wird angestrebt, möglichst seltene Wechsel der Wechseltische 140 durchzuführen.

Ein Bestückungsauftrag umfasst die Stückzahl der zu bestückenden Leiterplatten eines Leiterplattentyps. Zur Bestückung einer anhand der Bestückungsaufträge vorbestimmbaren Menge von Leiterplatten 120 können Rüstungen gebildet sein, die jeweils Vorräte von Bauelementen 155 von vorbestimmten Bauelementtypen 160 umfassen, wobei jede Leiterplatte der Menge der Leiterplatten 120 mit Bauelementen 155 der Rüstung vollständig bestückt werden kann. Eine Rüstung kann realisiert sein durch eine Anzahl an Wechseltischen 140. In der Darstellung von Figur 1 sind eine Festrüstung 165, deren Wechseltische 140 an der Bestückungslinie 110 angebracht sind, und eine Variantenrüstung 170, deren Wechseltische 140 von der Bestückungslinie 110 getrennt sind, gebildet. Es können eine oder mehrere Festrüstungen 165 und eine oder mehrere Variantenrüstungen 170 vorgesehen sein. Ein Fall ohne Variantenrüstungen 170 ist möglich.

Die Festrüstung 165 ist dazu eingerichtet, zumindest während eines langfristigen Planungshorizonts, der beispielsweise ein halbes Jahr oder mehr, ggf. ein Jahr betragen kann, bezüglich seiner Bauelementtypen 160 unverändert bzw. bestehen zu bleiben. Es können also im Bedarfsfall zwar Bauelemente 155 an den Wechseltischen 140 der Feststung 165 nachgefüllt werden, die Zuordnung von Bauelementtypen 160 zu Spuren der Wechseltische 140 bleibt jedoch unverändert. Sind mehrere Feströstungen 165 vorgesehen, so können diese innerhalb des Planungshorizonts gegeneinander ausgetauscht werden.

Eine Variantenrüstung 170 hingegen ist dazu eingerichtet, während des Planungshorizonts Bauelemente 155 unterschiedlicher Bauelementtypen 160 aufzunehmen, besteht aber nur temporär. Dazu werden üblicherweise die Wechseltische 170, während sie nicht an der Bestückungslinie 110 angebracht sind, von Bauelementen 155 vorbestimmter Bauelementtypen 160 abgerüstet und mit Bauelementen 155 anderer Bauelementtypen 160 aufgerüstet. Diese Umrüstung kann einen erheblichen Anteil manueller Arbeit umfassen und zeitaufwändig sein.

Eine Rüstfamilie, sei es eine Feströstungs-Rüstfamilie bzw. Variantenrüstungs-Rüstfamilie, ist bestimmt als eine Menge von Leiterplattentypen, deren Leiterplatten auf einer Bestückungslinie bestückt werden können, ohne die Menge der Bauelementtypen zu ändern, die an der Bestückungslinie für die Bestückung bereitgehalten werden. D.h. es muss nicht umgerüstet werden.

Eine Steuereinrichtung bzw. -vorrichtung 115 ordnet Leiterplattentypen 122, deren zugeordnete Leiterplatten 120 auf der Bestückungslinie 110 bestückt werden sollen, einer Rüstfamilie zu. Sie steuert auch die Bestückung der Leiterplatten. Eine Rüstfamilie ist eine Menge von Leiterplattentypen 122, deren Leiterplatten 120 vollständig mit Bauelementen 155 bestückt werden können, die in der zugeordneten Rüstung 165, 170 bereitgestellt sind. Eine Rüstfamilie ist/wird üblicherweise genau einer Rüstung 165, 170 zugeordnet und umgekehrt.

Eine oder mehrere Steuereinrichtungen, die jeweils für eine oder mehrere Bestückungslinien 110 die Steuerung-/Regelung des Baugruppenbestückungsprozesses auf den Bestückungslinien zur Erfüllung der Bestückungsaufträge eingerichtet ist/sind, kann/können jeweils mit einer (zentralen) Cloud bzw. Rechnerwolke über drahtgebundene und/oder drahtlose Netzwerktechniken verbunden sein.

Die Steuereinrichtung kann eine Recheneinheit umfassen, die mit einem nicht dargestelltem Datenspeicher bzw. -medium verbunden sein kann. Aus dem Datenspeicher können gegebenenfalls gespeicherte bzw. vorkonfigurierte Modelle der Bestückungssysteme abrufen werden. In die Steuereinrichtung können zudem eine oder mehrere nicht dargestellte Optimierungseinheiten integriert oder mit dieser gekoppelt sein, in denen sogenannte Solver eingesetzt werden können. Solver (Löser) sind spezielle mathematische Computerprogramme, die mathematische Probleme numerisch lösen können.

Eine nicht dargestellte Ausgabeeinheit der Steuerungseinheit kann das im Folgenden näher beschriebene Optimierungsergebnis in einer zur Steuerung und/oder zur Regelung der Bestückungsauftragserfüllung geeigneten Form liefern. Eine solche Form sollte computerlesbar sein z.B. ein oder mehrere Excellisten in CSV-Format.

Anschließend kann bewertet werden, vorzugsweise mittels Simulation, welche Auswirkungen das Optimierungsergebnis, umfassen eine optimierte Zuordnung der Leiterplattentypen auf den Betrieb der Bestückungslinie haben. Es soll eine Zielfunktion der genannten Optimierung ihr Maximum bzw. eine vorgebbare Kennzahl erreichen.

Zusätzlich und alternativ ist es möglich, dass die Steuereinrichtung andere computerlesbare Steuerungssignale aussendet bzw. in Empfang annimmt, um daraus in ihrer Recheneinheit den Steuerungs-/Regelungsprozess zu veranlassen.

Das Bestücken der Baugruppen bzw. Leiterplatten wird üblicherweise so durchgeführt, dass die Bauelemente 155 einzeln mittels Lötpaste an den Leiterplatten 120 fixiert werden. Anschließend können die bestückten Leiterplatten 155 in einem Reflow-Ofen fertig gestellt werden, in dem die Lötpaste vorübergehend aufgeschmolzen wird, sodass die Bauelemente 155 elektrisch und mechanisch mit Leiterbahnen an der Oberfläche der Leiterplatte 120 verbunden werden.

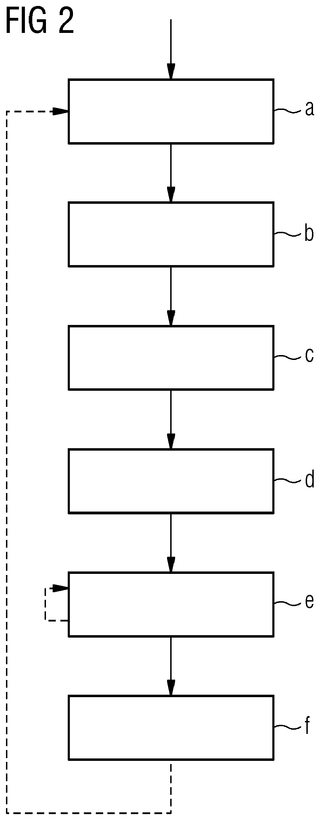

Figur 2 zeigt ein Ablaufdiagramm des erfindungsgemäßen Verfahrens umfassend folgende mit a bis f gekennzeichnete Schritte:

a: Erfassen einer Anzahl Leiterplattentypen mit dem jeweiligen Leiterplattentyp zugeordneten Leiterplatten, die auf der Bestückungslinie innerhalb des Planungshorizonts bestückt werden sollen;

b: Erfassen der Anzahl der Bauelementtypen zur Bestückung einer oder mehrerer Leiterplatten eines Leiterplattentyps,

c: Erfassen von Wahrscheinlichkeiten für das Eintreffen von Aufträgen zur jeweiligen Bestückung eines Leiterplattentyps innerhalb eines Zeitintervalls;

d: Zuordnen von Leiterplattentypen an eine Feströstungs-Rüstfamilie, wobei alle Bauelementtypen zur Bestückung einer Leiterplatte eines Leiterplattentyps der zugeordneten Leiterplattentypen hinsichtlich ihres Platzverbrauchs in den in der Feströstung verfügbaren Spuren Platz haben und in der Feströstung gerüstet werden;

e: Optimieren dieser Zuordnung der Leiterplattentypen derart, dass eine in einem Zeitintervall erwartete Anzahl der in der mindestens einen Variantenrüstung zu rüstenden Bauelementtypen minimiert wird,

f: Bestücken der Leiterplatten aller in den Zeitintervallen auszuführenden Aufträge auf der Bestückungslinie mit Hilfe der optimierten Zuordnung der Leiterplattentypen.

Optional in Schritt e: Für Schritt e können verschiedene Nebenbedingungen zusätzlich berücksichtigt werden, die beispielsweise in der nachfolgenden Formulierung eines Gemischt ganzzahligen Programms näher beschrieben werden.

Dieser Schritt kann auch übersprungen werden, dann folgt Schritt e nach Schritt f.

Optional wird das Verfahren wiederholt, um die Zuordnung der Leiterplattentypen gegebenenfalls weiter zu optimieren.

Um eine Optimierung der Zuordnung der Leiterplattentypen zu erreichen, können beliebige Optimierungsmethoden verwendet werden, beispielsweise auf der Basis von lokalen Suchverfahren oder metaheuristischen Algorithmen. Bei jedem Durchlauf der genannten Schritte wird die beste bislang bestimmte Zuordnung pseudo-zufällig oder nach einer Heuristik variiert, sodass sich veränderte Zuordnungen ergeben, von denen die optimale Zuordnung ausgewählt wird.

Bevorzugterweise erfolgt vor allem Schritt e durch Lösen eines Gemischt Ganzzahligen Programms. Optimierer (Solver) auf der Basis Gemischt Ganzzahliger Programmierungen sind - wie oben bereits erläutert - als kommerzielle Produkte erhältlich.

Im Folgenden wir ein Beispiel für eine MINLP- und MILP-Formulierung zur Optimierung der Zuordnung der Leiterplattentypen.

Erfindungsgemäß werden für eine HighMix-LowVolume-Linie Baugruppentypen für Festrüstungsfamilien ausgewählt werden, so dass die erwartete Anzahl der Rüstungen von Bauelementtypen zur Erstellung der variablen Rüstungen im folgenden Beispiel pro Tag minimiert wird. Damit wird der gesamte Rüstaufwand minimiert.

Bewertungs-Modell:

$Order_r$ Anzahl der prognostizierten Aufträge für die Baugruppe *r im* langfristigen Planungszeitraum
$T_L$ Anzahl der Tage im langfristigen Planungszeitraum
$T_K$ Anzahl der Tage im kurzfristigen Planungszeitraum (oben als Zeitintervall bezeichnet)

Es gelte, dass $Order_r \leq T_L/T_K$. (Falls dies nicht der Fall sein sollte, so setzt man $Order_r := T_L/T_K$.)

$p_r :=$ Wahrscheinlichkeit, dass die Baugruppe im kurzfristigen Planungszeitraum gefertigt wird .

Es wird angenommen, dass sich die Aufträge gleichmäßig auf die kurzfristigen Planungszeiträume verteilen.

$$p_r = \frac{T_K Order_r}{T_L}$$

Es wird ferner angenommen, dass die Aufträge unabhängig voneinander sind und dass in einem Kurzfrist-Planungszeitraum die Rüstungen der Rüstfamilie kaum Bauelementtyp-Überschneidungen besitzen. (Dies ist z.B. näherungsweise im Elektronikwerk Fürth der Fall). Ein Bauelementtyp wird somit höchstens einmal in einem kurzfristigen Planungszeitraum gerüstet.

Der Erwartungswert dafür, dass ein Bauelement c $\in$ C im kurzfristigen Planungszeitraum gerüstet werden muss, ergibt sich wie folgt:

$EW(c)$ = Wahrscheinlichkeit, dass mindestens ein Baugruppentyp r gefertigt werden muss, der den Bauelementtyp c enthält

= 1 - Wahrscheinlichkeit, dass keine dieser Baugruppentypen gefertigt werden muss

$$= 1 - \prod_{r \in R_c}(1 - p_r)$$

Als Erwartungswert für die Anzahl der zu rüstenden Bauelementtypen in einem kurzfristigen Planungszeitraum ergibt sich damit:

$$EW(\text{Anzahl zu rüstender Bauelementtypen}) = \sum_{c \in C} EW(c)$$

Im folgenden vereinfachten Beispiel ergeben sich folgende Erwartungswerte:

$r_A = \{c_1, c_2\}$ 50 Aufträge
$r_B = \{c_1, c_3\}$ 50 Aufträge

$$EW(c_1) = 1 - (1 - 0{,}5)^2 = 1 - 0{,}25 = 0{,}75$$

$r_A = \{c_1, c_2\}$ 90 Aufträge
$r_B = \{c_1, c_3\}$ 10 Aufträge

$$EW(c_1) = 1 - (1 - 0{,}9)(1 - 0{,}1) = 1 - 0{,}1 * 0{,}9 = 0{,}91$$

Doppel-Rüstungen von Bauelementtypen in unterschiedlichen variablen Rüstungen werden nicht berücksichtigt. Daten-Auswertungen aus einem Elektronikwerk haben gezeigt, dass die gebildeten Rüstungen kaum Überschneidungen von Bauelementtypen aufweisen. Somit kann diese Annahme getroffen werden.

Dem sollen die Festrüstungen mit dem Ziel optimiert werden, den Rüstaufwand für die variablen Rüstungen zu minimieren

$assign_{r,cl}$   Variable, die angibt, ob die Baugruppen des Typs $r$ der Festrüstung-Rüstfamilie $cl$ zugeordnet werden. (In diesem Fall nimmt sie den Wert 1 an, anderenfalls den Wert 0)

$assign_r$   Variable, die angibt, ob die Baugruppen des Typs $r$ keiner Festrüstungs-Rüstfamilie zugeordnet werden. (In diesem Fall nimmt sie den Wert 1 an, anderenfalls den Wert 0)

Es gilt:

$$assign_r = 1 - \sum_{cl \in Cl} assign_{r,cl}$$

Zielfunktion:

Minimiere den Erwartungswert, der insgesamt zu rüstenden Bauelemente. Der Rüstungsaufwand entsteht für die variablen Rüstung. Für die Festrüstungen entsteht in der Regel kein Rüstungsaufwand.

$$\sum_{c \in C} EW(c) \quad = \sum_{c \in C} 1 - \prod_{\substack{r \in R_c \\ r \notin Festrüstung}} (1 - p_r)$$
$$= \sum_{c \in C} 1 - \prod_{r \in R_c} (1 - p_r)^{assign_r}$$

Diese Zielfunktion ist hochgradig nichtlinear. Die dazugehörigen Optimierungsprobleme sind nur schwer lösbar. Deshalb wird zusätzlich auch ein heuristischer Lösungsansatz mit einer heuristischen lineare Zielfunktion vorgeschlagen. Diese Zielfunktion wird im Folgenden hergeleitet.

Zielfunktion für heuristischen MIP Lösungsansatz:

$$Min \sum_{c \in C} EW(c) \quad \Leftrightarrow \quad Max \sum_{c \in C} \prod_{r \in R_c} (1 - p_r)^{assign_r}$$

Auf Grund der binären Variablen, gilt für die Faktoren:

$$(1 - p_r)^{assign_r} = 1 - p_r \, assign_r$$

Das Produkt lässt sich Zerlegen in lineare Terme und Terme höherer Ordnung

$$\prod_{r \in R_c} (1 - p_r \, assign_r)$$

$$= 1 - \sum_{r \in R_c} p_r \, assign_r + \sum_{r_i \in R_c} \sum_{\substack{r_j \in R_c \\ j > i}} p_{r_i} p_{r_j} assign_{r_i} \, assign_{r_j} - \dots$$

Als Heuristik wird vorgeschlagen, nur die Summe der linearen Anteile zu minimieren.

$$Min \sum_{c \in C} \sum_{r \in R_c} p_r \, assign_r$$

Mit Comps$_r$ wird die Anzahl der Bauelemente der Baugruppe r bezeichnet. Damit gilt:

$$Min \sum_{c \in C} \sum_{r \in R_c} p_r \, assign_r$$
$$\Leftrightarrow Min \sum_{c \in C} \sum_{r \in R_c} Order_r \, assign_r$$
$$\Leftrightarrow Max \sum_{c \in C} \sum_{r \in R_c} Order_r \sum_{cl \in Cl} assign_{r,cl}$$

Durch Änderung der Reihenfolge, in der aufsummiert wird, erhält man:

$$\sum_{c \in C} \sum_{r \in R_c} \sum_{cl \in Cl} Order_r \, assign_{r,cl} = \sum_{cl \in Cl} \sum_{r \in R} Order_r \, Comps_r \, assign_{r,cl}$$

Und somit ergibt sich als Zielfunktion für eine Heuristik zum Minimieren des gesamten Rüstaufwands $\sum_{c \in C} EW(c)$

$$Min \sum_{c \in C} EW(c) \rightarrow Min \sum_{c \in C} \sum_{r \in R_c} p_r \, assign_r$$
$$\Leftrightarrow Max \sum_{cl \in Cl} \sum_{r \in R} Order_r \, Comps_r \, assign_{r,cl}$$

Als heuristischer Lösungsansatz zur Minimierung der zu rüstenden Bauelementtypen für die variablen Rüstungen wird folgendes MINLP bzw. MIP-Modell vorgeschlagen:

MINLP/MIP-Modell:

Es gelten die folgenden Bezeichnungen.

Indices

| C | Menge der Bauelementtypen |
|---|---|
| R | Menge der Baugruppentypen |
| $R_c$ | Menge der Baugruppentypen mit Bauelementtyp c |
| Cl | Menge der Festrüstungen/Festrüstungsfamilien |

Parameter

| Width$_c$ | Platzverbrauch eines Bauelementtyps c in Spuren |
|---|---|
| LineCap | Anzahl der Spuren der Bauelementtypen, die in der Rüstung einer Rüstfamilie Platz haben |
| LowerTimeLimit | Untere Produktionszeitschranke aller der Festrüstungsfamilie zugewiesenen Baugruppen |
| ProdTime$_r$ | Produktionszeit einer Baugruppe des Typs |
| r | auf der Linie |
| Order$_r$ | Anzahl prognostizierten Aufträge für den zu fertigenden Baugruppentyp r |
| Comps$_r$ | Anzahl der Bauelementtypen, mit denen Baugruppentyp r zu bestücken ist |

Binärvariablen

| assign$_{r,cl}$ | Variable, die angibt, ob die Baugruppen des Typs r der Festrüstungs-Rüstfamilie cl zugeordnet werden. (In diesem Fall nimmt sie den Wert 1 an, anderenfalls den Wert 0) |
|---|---|
| setup$_{c,cl}$ | Variable, die angibt ob der Bauelementtyp c in der Rüstung der Festrüstungs-Rüstfamilie cl gerüstet werden muss. (In diesem Fall nimmt sie den Wert 1 an, anderenfalls den Wert 0) |

MINLP-Zielfunktion

$$Maximiere \sum_{c \in C} \prod_{r \in R_c} (1 - p_r)^{assign_r}$$

MIP-Zielfunktion

$$Maximiere \sum_{cl \in Cl} \sum_{r \in R} Order_r \, Comps_r \, assign_{r,cl}$$

Nebenbedingungen:

(1) Jeder Baugruppentyp darf höchstens einer Rüstfamilie zugeordnet sein.

$$\sum_{cl \in Cl} \text{assign}_{r,cl} \leq 1 \qquad r \in R$$

(2) Die Bauelementtypen der Baugruppentypen einer Rüstfamilie müssen in eine Rüstung passen.

$$\sum_{c \in C} \text{Width}_c \, setup_{c,cl} \leq LineCap \qquad cl \in Cl$$

(3) Alle Bauelementtypen einer Rüstfamilie müssen in der Rüstung der Rüstfamilie gerüstet werden

$$\sum_{r \in R_c} \text{assign}_{r,cl} \leq |R_c| setup_{c,cl} \qquad c \in C, cl \in Cl$$

(4) Optional: Die Summe der Produktionszeiten der Baugruppentypen einer Rüstfamilie darf die untere Produktionszeitschranke nicht unterschreiten.

$$\sum_{cl \in Cl} \sum_{r \in R} assign_{r,cl} \, \text{ProdTime}_r \geq LowerTimeLimit$$

(5) Für MINLP-Variante

$$assign_r = 1 - \sum_{cl \in Cl} assign_{r,cl} \qquad r \in R$$

(6) Variablenrestriktionen

$$\text{assign}_{r,cl} \in \{0,1\} \qquad r \in R, cl \in Cl$$

$$\text{setup}_{c,cl} \in \{0,1\} \qquad c \in C, cl \in Cl$$

$$\text{assign}_r \in \{0,1\} \qquad r \in R$$

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Die Implementierung der vorstehend beschriebenen Prozesse oder Verfahrensabläufe/-schritte kann anhand von Befehlen bzw. Instruktionen erfolgen, die auf computerlesbaren, nichtflüchtigen Speichermedien oder in flüchtigen Computerspeichern (im Folgenden zusammenfassend als computerlesbare Speicher bezeichnet) vorliegen. Computerlesbare Speicher sind beispielsweise flüchtige Speicher wie Caches, Puffer oder RAM sowie nichtflüchtige Speicher wie Wechseldatenträger, Festplatten, usw.

Die vorstehend beschriebenen Funktionen oder Schritte können dabei in Form zumindest eines Instruktionssatzes in/auf einem computerlesbaren Speicher vorliegen. Die Funktionen oder Schritte sind dabei nicht an einen bestimmten Instruktionssatz oder an eine bestimmte Form von Instruktionssätzen oder an ein bestimmtes Speichermedium oder an einen bestimmten Prozessor oder an bestimmte Ausführungsschemata gebunden und können durch Software, Firmware, Microcode, Hardware, Prozessoren, integrierte Schaltungen usw. im Alleinbetrieb oder in beliebiger Kombination ausgeführt werden. Dabei können verschiedenste Verarbeitungsstrategien zum Einsatz kommen, beispielsweise serielle Verarbeitung durch einen einzelnen Prozessor oder Multiprocessing oder Multitasking oder Parallelverarbeitung usw.

Die Instruktionen können in lokalen Speichern abgelegt sein, es ist aber auch möglich, die Instruktionen auf einem entfernten System z.B. Cloud abzulegen und darauf via Netzwerk zuzugreifen.

Unter "rechner-/computergestützt" bzw. "computerimplementiert" kann im Zusammenhang mit der Erfindung beispielsweise eine Implementierung des Verfahrens verstanden werden, bei dem insbesondere ein Prozessor bzw. eine Recheneinheit, der Teil des Steuerungssystems bzw. Steuereinrichtung bzw. der (Steuerungs- bzw. Verarbeitungs-)vorrichtung bzw. -einheit und/oder eines Computers und/oder eines oder mehrerer Dienste in einer Rechnerwolke (Cloud) eines Diensterbringers sein kann, mindestens einen Verfahrensschritt des Verfahrens ausführt.

Sofern es in der nachfolgenden Beschreibung nicht anders angegeben ist, beziehen sich die Begriffe "abbilden", "nachbilden", "empfangen", "anwenden", "ausgeben", "bereitstellen" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt oder vorliegen können.

Der Begriff "Prozessor", "zentrale Signalverarbeitung", "Steuereinheit" oder "Datenauswertemittel", wie hier verwendet, umfasst Verarbeitungsmittel im weitesten Sinne, also beispielsweise Server, Universalprozessoren, Grafikprozessoren, digitale Signalprozessoren, anwendungsspezifische integrierte Schaltungen (ASICs), programmierbare Logikschaltungen wie FPGAs, diskrete analoge oder digitale Schaltungen und beliebige Kombinationen davon, einschließlich aller anderen dem Fachmann bekannten oder in Zukunft entwickelten Verarbeitungsmittel. Prozessoren können dabei aus einer oder mehreren Systemen bzw. Vorrichtungen bzw. Einrichtungen bzw. Einheiten bestehen. Besteht ein Prozessor aus mehreren Vorrichtungen, können diese zur parallelen oder sequentiellen Verarbeitung bzw. Ausführung von Instruktionen ausgelegt bzw. konfiguriert sein. Unter einer "Speichereinheit" kann im Zusammenhang mit der Erfindung beispielsweise ein computerlesbares Speichermedium in Form von Arbeitsspeicher (engl. Random-Access Memory, RAM) oder eine Festplatte verstanden werden.

## Patentansprüche

1. Verfahren zum Bestücken von Leiterplatten (120) mittels mehrerer Rüstungen (165, 170) auf einer Bestückungslinie (110), wobei eine Rüstung (165, 170) eine Anzahl an Bauelementtypen (160) umfasst, die zur Bestückung einer der Rüstung (165, 170) zugeordneten Rüstfamilie (210, 215) von Leiterplattentypen (122) ausreicht,

   - wobei eine Rüstung (165, 170) realisierbar ist durch eine Anzahl von Wechseltischen (140), die an der Bestückungslinie (110) angebracht sind und die Vorräte von Bauelementen (155) der Bauelementtypen (160) umfassen,

     - wobei ein Planungshorizont zum Bestücken der Leiterplatten in mehrere Zeitintervalle fester Länge unterteilt ist und während eines Zeitintervalls unterschiedliche Rüstungen (165, 170) an der Bestückungslinie (110) angebracht werden können,
     - wobei von den Rüstungen mindestens eine Festrüstung (165) gebildet wird, die während des Planungshorizonts unverändert bleibt und mehrfach an der Bestückungslinie (110) eingesetzt werden kann,
     - und wobei mindestens eine Variantenrüstung (170) während des Planungshorizonts gebildet wird, die nur temporär auf Wechseltischen (140) aufgerüstet und nach der Bestückung von Leiterplatten (120) einer Rüstfamilie wieder abgerüstet wird,

   und wobei das Verfahren folgende Schritte umfasst:

     a) Erfassen einer Anzahl Leiterplattentypen (122) mit dem jeweiligen Leiterplattentyp zugeordneten Leiterplatten (120), die auf der Bestückungslinie (110) innerhalb des Planungshorizonts (205) bestückt werden sollen;
     b) Erfassen der Anzahl der Bauelementtypen zur Bestückung einer oder mehrerer Leiterplatten eines Leiterplattentyps,
     c) Erfassen von Wahrscheinlichkeiten für das Eintreffen von Aufträgen zur jeweiligen Bestückung eines Leiterplattentyps innerhalb eines Zeitintervalls;
     d) Zuordnen (315) von Leiterplattentypen (122) an eine Festrüstungs-Rüstfamilie, wobei alle Bauelementtypen zur Bestückung einer Leiterplatte eines Leiterplattentyps der zugeordneten Leiterplattentypen hinsichtlich ihres Platzverbrauchs in den in der Festrüstung verfügbaren Spuren Platz haben und in der Festrüstung gerüstet werden;

e) Optimieren dieser Zuordnung der Leiterplattentypen derart, dass eine in einem Zeitintervall erwartete Anzahl der in der mindestens einen Variantenrüstung zu rüstenden Bauelementtypen minimiert wird,
f) Bestücken der Leiterplatten (120) aller in den Zeitintervallen auszuführenden Aufträge auf der Bestückungslinie (110) mit Hilfe der optimierten Zuordnung der Leiterplattentypen.

2. Verfahren nach Anspruch 1, **dadurch gekennzeichnet, dass** eine prognostizierte Anzahl an Aufträgen für einen Leiterplattentyp innerhalb des Planungshorizonts erfasst wird und die Wahrscheinlichkeit für das Eintreffen von Aufträgen zur jeweiligen Bestückung eines Leiterplattentyps innerhalb eines Zeitintervalls sich aus der prognostizierten Anzahl an Aufträgen dividiert durch die Anzahl an Zeitintervallen ergibt, wobei maximal ein Auftrag für einen Leiterplattentyp pro Zeitintervall erledigt werden kann.

3. Verfahren nach Anspruch 1 oder 2, **dadurch gekennzeichnet, dass** das genannte Optimieren der Zuordnung der Leiterplattentypen mittels Gemischt Ganzzahliger Nicht Linearer Programmierung erfolgt.

4. Verfahren nach Anspruch 3, **dadurch gekennzeichnet, dass** in der Gemischt Ganzzahligen Nicht Linearen Programmierung die nichtlineare Zielfunktion durch eine lineare Zielfunktion approximiert wird.

5. Verfahren nach Anspruch 4, **dadurch gekennzeichnet, dass** die Minimierung der nichtlinearen Zielfunktion in Form von einer Minimierung der erwarteten Anzahl der in der mindestens einen Variantenrüstung zu rüstenden Bauelementtypen durch Maximierung der linearen Zielfunktion in Form von der Summe der prognostizierten Aufträge multipliziert mit der Anzahl der Bauelementtypen der Leiterplattentypen, die den Festrüstungs-Rüstfamilien zugeordnet sind, approximiert wird.

6. Verfahren nach einem der Ansprüche 4 oder 5, **dadurch gekennzeichnet, dass** die genannte Optimierung der Zuordnung der Leiterplattentypen mit Hilfe einer Gemischt Ganzzahligen Linearen Programmierung mit der linearen Zielfunktion durchgeführt wird.

7. Steuereinrichtung (115) zum Bestücken von Leiterplatten (120) mittels einer Rüstung (165, 170) auf einer Bestückungslinie (110), wobei die Rüstung (165, 170) eine Anzahl an Bauelementtypen (160) umfasst, die zur Bestückung einer der Rüstung (165, 170) zugeordneten Rüstfamilie von Leiterplattentypen (122) ausreicht,

- wobei die Rüstung (165, 170) realisierbar ist durch eine Anzahl von Wechseltischen (140), die an der Bestückungslinie (110) angebracht sind und die Vorräte von Bauelementen (155) der Bauelementtypen (160) umfassen,
- wobei ein Planungshorizont zum Bestücken der Leiterplatten in mehrere Zeitintervalle fester Länge unterteilt ist und während eines Zeitintervalls unterschiedliche Rüstungen (165, 170) an der Bestückungslinie (110) angebracht werden können,
- wobei von den Rüstungen mindestens eine Festrüstung (165) gebildet wird, die während des Planungshorizonts unverändert bleibt und mehrfach an der Bestückungslinie (110) eingesetzt werden kann,

- und wobei mindestens eine Variantenrüstung (170) während des Planungshorizonts gebildet wird, die nur temporär auf Wechseltischen (140) aufgerüstet und nach der Bestückung von Leiterplatten (120) einer Rüstfamilie wieder abgerüstet wird,

und wobei die Steuereinrichtung (115) dazu eingerichtet ist, die Schritte a) bis f) von Anspruch 1 auszuführen.

8. Computerprogrammprodukt umfassend einen durch eine Recheneinheit ausführbaren Programmkode oder mehrere durch mehrere Recheneinheiten ausführbare und zusammenwirkende Programmkodemodule, welches oder welche Befehle aufweisen, die die Ausführung des Verfahrens nach einem der vorhergehenden Verfahrensansprüche auf dem Steuerungssystem nach vorhergehenden Anspruch veranlassen, wobei das Computerprogrammprodukt auf einem computerlesbaren Medium gespeichert sein kann.

# FIG 1

FIG 2

Europäisches
Patentamt

European
Patent Office

Office européen
des brevets

# EUROPÄISCHER RECHERCHENBERICHT

**Nummer der Anmeldung**

**EP 23 15 9766**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | DE 10 2015 200420 A1 (SIEMENS AG [DE]) 14. Juli 2016 (2016-07-14) * Absatz [0001] – Absatz [0071]; Abbildung 1 * ----- | 1-8 | INV. H05K13/08 G06Q10/063 G06Q10/04 G06Q50/04 G05B19/418 |
| A | DE 10 2014 222936 A1 (SIEMENS AG [DE]) 12. Mai 2016 (2016-05-12) * Absatz [0030] – Absatz [0061]; Abbildungen 1-3 * ----- | 1-8 | |

**RECHERCHIERTE SACHGEBIETE (IPC)**

H05K
G06Q
G05B

Der vorliegende Recherchenbericht wurde für alle Patentansprüche erstellt

| Recherchenort | Abschlußdatum der Recherche | Prüfer |
|---|---|---|
| Den Haag | 14. August 2023 | Seifert, Frank |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 23 15 9766

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-08-2023

| Im Recherchenbericht angeführtes Patentdokument | Datum der Veröffentlichung | Mitglied(er) der Patentfamilie | | Datum der Veröffentlichung |
|---|---|---|---|---|
| DE 102015200420 A1 | 14-07-2016 | CN | 107114016 A | 29-08-2017 |
| | | DE | 102015200420 A1 | 14-07-2016 |
| | | EP | 3225086 A1 | 04-10-2017 |
| | | US | 2017374745 A1 | 28-12-2017 |
| | | WO | 2016113021 A1 | 21-07-2016 |
| DE 102014222936 A1 | 12-05-2016 | CN | 107114013 A | 29-08-2017 |
| | | DE | 102014222936 A1 | 12-05-2016 |
| | | EP | 3180969 A1 | 21-06-2017 |
| | | JP | 6448786 B2 | 09-01-2019 |
| | | JP | 2017538287 A | 21-12-2017 |
| | | US | 2017318716 A1 | 02-11-2017 |
| | | WO | 2016074851 A1 | 19-05-2016 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2893791 B1